# EUROPEAN PATENT APPLICATION

(11) **EP 2 408 109 A1**
(43) Date of publication of application: **18.01.2012**
(21) Application number: 10169706.8
(22) Date of filing: 15.07.2010
(51) Int. Cl.: H03K 3/84, H03K 7/08

(54) **Apparatus for providing pulse width modulated control signals to an inverter**

(71) Applicant: SIEMENS AKTIENGESELLSCHAFT, 80333 München (DE)
(72) Inventor: Carter, Robert, Knutsford, Cheshire WA16 8XU (GB)
(74) Representative: Morgan, Marc

(57) **Abstract**

A controller is used to set the pulse period for use within a control period in a pulse width modulator. This is made random between control pulse periods which reduces interferences and resonances in a load such as an AC motor and anything mechanically coupled to it. An additional advantage is that the current delivered to the load is more accurately sensed when using an integrating current sensor.

## Description

This invention relates to apparatus for providing pulse width modulated control signals to an inverter for an ac powered device. The invention finds particular application to the field of induction motors

When an induction motor is supplied by the mains, it is presented with a nominally perfect set of equal sine-waves of voltage 120 degrees apart. Under these circumstances the motor current is generally also perfectly sinusoidal. When the motor is inverter driven, the driving voltage is no longer perfectly sinusoidal, and can be thought of as containing harmonics. This leads to current harmonics which add ripple to the fundamental current waveform. As the performance and control of the motor is almost exclusively concerned with its fundamental frequency currents and voltages, the ripple can degrade the motor control.

In most inverters, the current ripple problem is addressed by carefully sampling the current at a particular time instant in the Pulse Width Modulation (PWM) pulse where the current should be near the middle of the ripple. There are two problems with this approach. Firstly, any sampling system is inherently noise sensitive at the instant of sampling and secondly it is practically impossible to sample perfectly in the middle of the ripple instantaneously in all measured phases.

In some current forms of inverters, the current ripple problem is addressed by integrating the current measurement over an exactly integral number of PWM pulses. However, this approach is only a partial solution since it suffers from two problems. Firstly, the finite integration window (in preference to an instantaneous sample window) results in a reduction in the measured current compared with the actual current. This can be compensated by software but does result in a motor frequency limitation. Secondly, if the integration window is a fixed size, equal to the control period, the pulse frequency is constrained to be N times the control frequency where N is an integer. This is why the pulse frequencies available in some arrangements are always a multiple of 2kHz.

Pulse frequency randomisation is used to prevent mechanical resonances in the load, which may be excited by the pulse frequency and its harmonics. It can also protect from electrical resonances in mains supplies and EMC filter components. In its purest form, every half pulse period is a random length (random within approximately a 2:1 range of pulse periods). In practice, this can be difficult or inconvenient to achieve and drives have been known to use various procedures to approximate to the fully random ideal. A typical simplification, is to alter the random pulse length every few milliseconds instead of every pulse or half pulse.

Tests have shown that such simplified randomised PWM schemes still convey the same advantages as the fully random ideal.

The random number generator used to invent the random pulse periods can easily be implemented as a linear feedback shift register configured as a PRBS (pseudo- random binary sequencer).

The randomised pulse period would result is a randomised control period since the control period must contain an integral number of pulse periods. Random variation of the control period would be problematic for the controller.

According to the invention there is provided apparatus for providing pulse width modulated control signals to an inverter. The apparatus includes a pulse width modulator providing the control outputs in accordance with a pulse width modulation scheme and a controller for setting the pulse width of the pulses under the modulation scheme such that for the pulse width is varied between control periods such that pulse widths in adjacent control periods are different.

A specific embodiment of the invention will now be described, by way of example only, with reference to the drawings in which:
Figure 1 shows an AC motor control arrangement of a pulse width modulator, an inverter and an AC motor; and
Figures 2 and 3 show pulse periods set in relation to control periods.

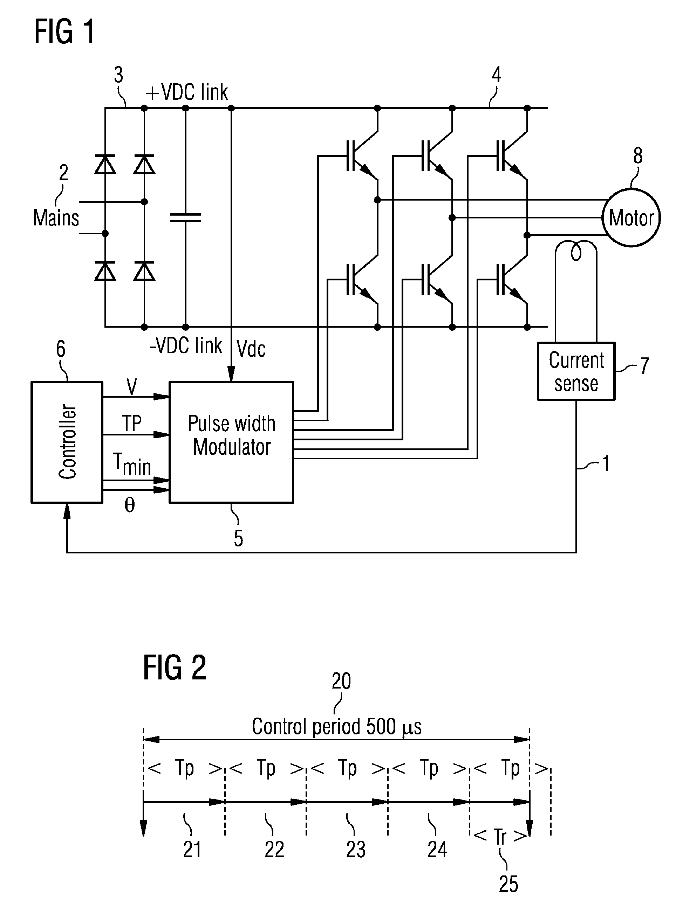

As is shown in figure 1, an AC motor control arrangement 1 includes a mains supply 1, a rectifier 3 converting the AC supply voltage to a DC link voltage, an inverter 4 for converting the DC link voltage to the required motor supply, a pulse width modulator 5 provides control signals to the switches in the inverter to generate the required motor supply, a controller 6 for providing control signals to the pulse width modulator 5 and a current sensor 7 responsive to the current supplied to the motor 8 to provide a signal representative thereof to the controller 6.

The pulse width modulator 5 will be understood by the person skilled in the art to provide pulses to the inverter switches in accordance with a pulse width modulation scheme. This causes the switches in the inverter to selectively connect one of the phase outputs to the motor to the DC link. In combination the outputs provide a rotating phase supply to the ac motor to drive the motor. In prior art arrangements the scheme will have a fixed control period within which the desired pulse must lie. In this embodiment however, whilst the control period is fixed the pulse period within a given control period is varied. The pulse period to be used Tp is set by the controller 6 which provides Tp, V, theta and T min where V and theta are the variable motor control data, Tmin is the (fixed) minimum pulse period and Tp as stated above the pulse period to be used within this control period. The controller 6 includes a random number generator to provide a random pulse period (Tp).

Figure 2 shows a control period 20 for the pulse width modulator 5. This has time between the start and end of the period of 500ps (500 micro seconds) which is a typical value in a modulator of this type. The pulse periods fit within the control period 20. In this case there are five pulse periods, 21 to 24 and 25. Pulses 21 to 24 have an identical length of 110 µs. Thus these periods leave a fifth pulse 25 only 60 µs. The last pulse is thus arranged to have a period of this to fit within the control period. In the next control period a different value of Tp will be used to provide between different control periods a desired variation.

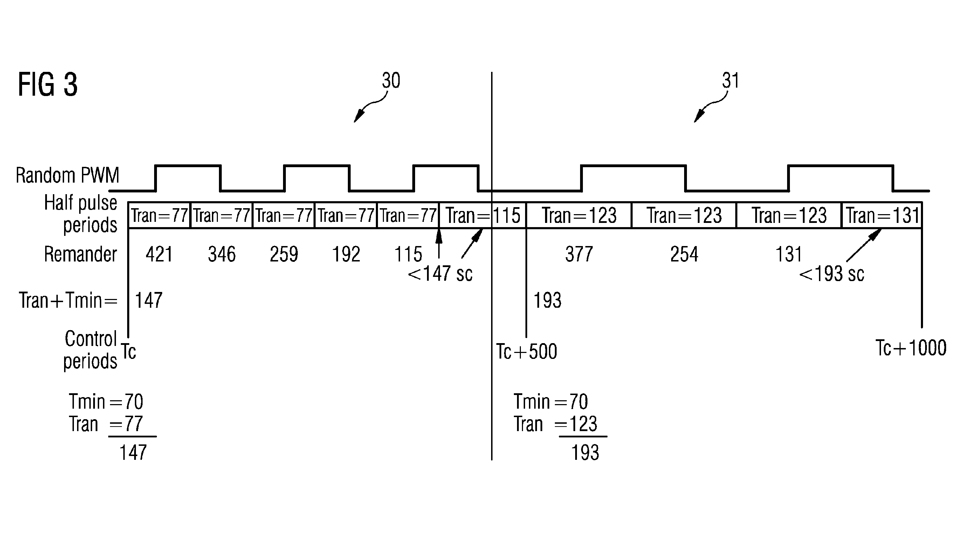

Figure 3 shows another example but this time with two control periods 30 and 31 of 500 µs depicted in relation to a random PWM waveform. It will be seen that the PWM waveform over control period 30 comprises three pulses. Over control period 31 it comprises two pulses of a longer duration than those over the period 30.

In the control period 30 the Tmin value is 70 µs and a random value Tran is chosen to be 77 µs. A value of Tran plus Tmin then comes to 147. This means that if the remaining time available within the control period is less than this a pulse of 77 µs will not fit within the remaining time. Then the pulse length to be used is not 77 µs but the remainder. Tmin is a minimum pulse period, which is sent just once (ever) by the controller. The remainder is calculated autonomously by the modulator - so the modulator is given a random pulse period just once in a control cycle and when it gets near the end of the control period the modulator decides when to put the remainder length pulse in to exactly fill the control cycle. The data is sent to the modulator from the controller just once per control cycle.

In the next control period 31, a different value for the pulse period is used, in this case it is 123 µs. Tmin is the same value and hence Tran +Tmin= 70+123=193. When the remainder is determined to be less than 193, the pulse period is set to be the remainder which in the case depicted is 131.

Preferably, the pulse period is selected to be in the range 2:1 In the example above the (random) pulse periods were chosen from the range 62.5us to 125us. In figure 3 it will be seen that the pulse in the second control period is 123 and thus lies within the range of 2:1. There is no benefit in having a greater than 2:1 range, but a smaller range can begin to resonate.

## Claims

1. Apparatus for providing pulse width modulated control signals to an inverter which apparatus comprising: a pulse width modulator providing the control outputs in accordance with a pulse width modulation scheme and a controller for setting the pulse period of the pulses under the modulation scheme such that for the pulse period is varied between control periods such that pulse periods in adjacent control periods are different.

2. Apparatus as claimed in claim 1 wherein the pulse periods within a given control period are set to be the same except for the last pulse.

3. Apparatus as claimed in claim 2 wherein the modulator determines the time remaining in the control period into which the pulse is to fit and compares the determined time remaining with the pulse duration used in the last pulse to determine whether the last pulse period will fit and, in the event that it will not, setting the pulse period to be used to be have a duration of the time remaining.

4. Apparatus as claimed in any preceding claim wherein pulse periods between adjacent control periods are within the ration of two to one.

5. A voltage source inverter for providing a multiphase supply to an ac motor comprising apparatus as claimed in any preceding claim and an inverter responsive to the apparatus and connected to a dc voltage source to selectively switch the voltage source to provide a multiphase supply to the ac motor.

6. A voltage source inverter as claimed in claim 5 comprising a current sensor providing a signal to the controller representing the current supplied to the ac motor.
